# EUROPEAN PATENT APPLICATION

(11) **EP 4 145 193 A1**
(43) Date of publication of application: **08.03.2023**
(21) Application number: 21795483.3
(22) Date of filing: 27.04.2021
(51) Int. Cl.: G02B 5/20, G02B 5/08

(54) **WAVELENGTH CONVERSION ELEMENT AND METHOD FOR MANUFACTURING WAVELENGTH CONVERSION ELEMENT**

(30) Priority: 28.04.2020 JP 2020079470
(71) Applicant: Kyocera Corporation, Kyoto-shi Kyoto 612-8501 (JP)
(72) Inventor: NIINO Noritaka, Kyoto-shi, Kyoto 612-8501 (JP)
(74) Representative: Viering, Jentschura & Partner mbB Patent- und Rechtsanwälte
(86) International application number: PCT/JP2021/016818
(87) International publication number: WO 2021/221062

(57) **Abstract**

A wavelength conversion element converts excitation light to light with a different wavelength. The wavelength conversion element includes a substrate including an upper surface, and a wavelength converter on the upper surface of the substrate. The wavelength converter includes a phosphor including a plurality of phosphor particles, molten glass in contact with the plurality of phosphor particles and binding the plurality of phosphor particles to one another, and voids at least between the plurality of phosphor particles, in the molten glass, or between the plurality of phosphor particles and the molten glass. A maximum area of areas of the voids is less than a maximum area of areas of the plurality of phosphor particles in a cross-sectional view of the wavelength converter.

## Description

### TECHNICAL FIELD

The present disclosure relates to a wavelength conversion element and a method for manufacturing a wavelength conversion element.

### BACKGROUND OF INVENTION

Known wavelength conversion elements convert laser light to light with a different wavelength using a phosphor. For example, Patent Literature 1 describes a phosphor body containing phosphor particles held together with a binder of silicon dioxide (SiO₂).

### CITATION LIST

### PATENT LITERATURE

Patent Literature 1: Japanese Unexamined Patent Application Publication No. 2013-35953

### SUMMARY

### PROBLEM TO BE SOLVED

After exposure to laser light for a long time or with high power, a wavelength conversion element may have its phosphor degraded under heat from the laser light and may reduce its wavelength conversion capability. The heat resistance of the wavelength conversion element is to be improved.

### SOLUTION TO PROBLEM

A wavelength conversion element and a method for manufacturing a wavelength conversion element are described.

In an aspect, a wavelength conversion element converts excitation light to light with a different wavelength. The wavelength conversion element includes a substrate including an upper surface, and a wavelength converter on the upper surface of the substrate. The wavelength converter includes a phosphor including a plurality of phosphor particles, molten glass in contact with the plurality of phosphor particles and binding the plurality of phosphor particles to one another, and voids at least between the plurality of phosphor particles, in the molten glass, or between the plurality of phosphor particles and the molten glass. A maximum area of areas of the voids is less than a maximum area of areas of the plurality of phosphor particles in a cross-sectional view of the wavelength converter.

In an aspect, a method for manufacturing a wavelength conversion element is a method for manufacturing a wavelength conversion element including a wavelength converter for converting excitation light to light with a different wavelength. The method includes forming a powder filler comprising phosphor powder and glass powder, heating the powder filler to form a presintered compact, applying pressure to the presintered compact maintained at a temperature higher than or equal to a melting point of the glass powder and lower than a temperature at which a phosphor loses fluorescence, and cooling the presintered compact under the pressure to form the wavelength conversion element.

### ADVANTAGEOUS EFFECT

For example, the resistance to laser radiation is improved.

### BRIEF DESCRIPTION OF THE DRAWINGS

FIG. 1 is a cross-sectional view of a wavelength conversion element according to an embodiment.
FIG. 2 is a cross-sectional view of a wavelength converter.
FIG. 3 is a graph showing the resistance to laser radiation and the total luminous flux of the wavelength converter versus the porosity of the wavelength converter.
FIG. 4 is a flowchart showing processing for manufacturing the wavelength converter.
FIG. 5 is a cross-sectional view of the wavelength converter illustrating a manufacturing process.
FIG. 6 is a cross-sectional view of the wavelength converter illustrating a manufacturing process.
FIG. 7 is a cross-sectional view of the wavelength converter illustrating a manufacturing process.
FIG. 8 is a cross-sectional view of the wavelength converter illustrating a manufacturing process.
FIG. 9 is a cross-sectional view of the wavelength converter illustrating a manufacturing process.
FIG. 10 is a view of the wavelength converter illustrating voids on a surface facing a substrate.
FIG. 11 is a partial cross-sectional view of the wavelength converter and the substrate joined with solder.
FIG. 12 is a perspective view of a wavelength conversion element according to a variation of the embodiment.
FIG. 13 is a flowchart showing processing for manufacturing a wavelength converter.
FIG. 14 is a perspective view of a substrate in a variation of the embodiment.
FIG. 15 is a cross-sectional view of the substrate in the variation of the embodiment.

### DESCRIPTION OF EMBODIMENTS

A wavelength conversion element converts excitation light such as laser light to light with a different wavelength using a phosphor. For example, a wavelength conversion element may contain phosphors that emit red (R) fluorescence, green (G) fluorescence, and blue (B) fluorescence. Such a wavelength conversion element can convert violet laser light to pseudo white light.

The red, green, and blue phosphors typically have a heat resistance of up to about 400 °C. To increase the light intensity of fluorescence emitted from the phosphors, the energy of the laser light may be increased. However, this may degrade the phosphors under heat from the laser light.

The inventor of the present disclosure has developed a technique that allows a wavelength conversion element containing a phosphor to have higher resistance to laser radiation. Embodiments of the technique will now be described with reference to the drawings.

### Embodiments

### Structure

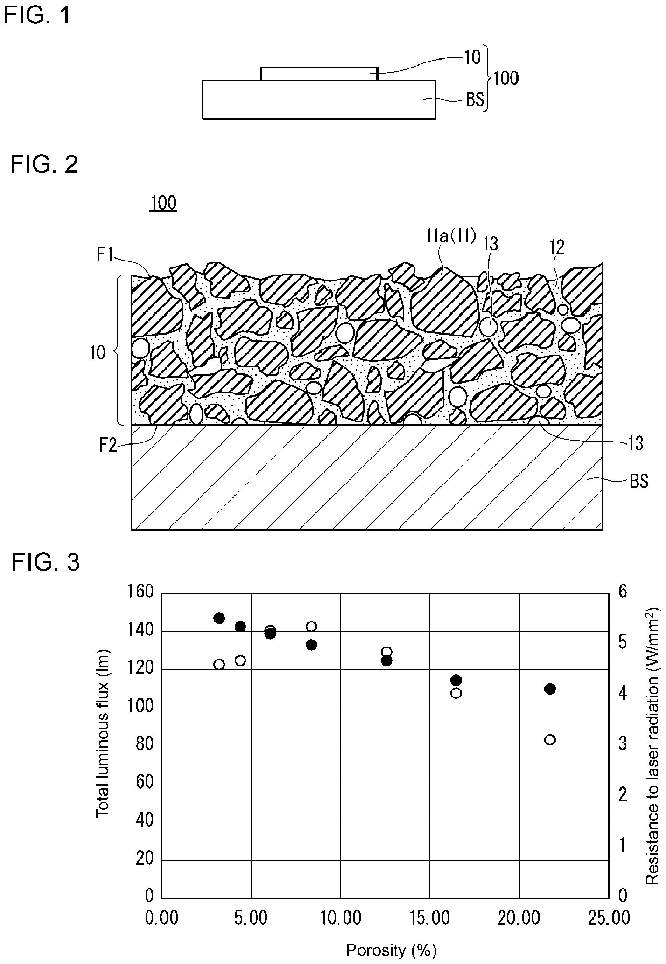

FIG. 1 is a cross-sectional view of a wavelength conversion element 100 according to an embodiment. As illustrated in FIG. 1, the wavelength conversion element 100 includes a substrate BS being a plate, and a wavelength converter 10 located on a main surface of the substrate BS. The wavelength converter 10 has a cross section with a complicated microscopic structure, which is not illustrated in the schematic view.

FIG. 2 is a schematic cross-sectional view of the wavelength converter 10 based on an image obtained with a scanning electron microscope (SEM). As illustrated in FIG. 2, the wavelength converter 10 includes multiple particles of phosphor 11, molten glass 12, and voids 13 being spaces without any phosphor 11 or molten glass 12.

The phosphor 11 includes multiple phosphor particles 11a. The phosphor 11 includes a phosphor (red phosphor) that emits red (R) fluorescence in response to laser light, a phosphor (green phosphor) that emits green (G) fluorescence in response to laser light, and a phosphor (blue phosphor) that emits blue (B) fluorescence in response to laser light. The red, green, and blue phosphors are not distinguished from one another in FIG. 2. For example, the phosphor 11 contains rare earths such as europium (Eu), cerium (Ce), and yttrium (Y) as phosphates, oxides, silicates, nitrides, fluorides, aluminates, sulfides, or other compounds.

The molten glass 12 binds the phosphor particles 11a to one another. The molten glass 12 has portions in direct contact with the phosphor particles 11a and serves as a heating medium that directly conducts heat from the phosphor 11. Laser light applied to an upper surface F1 (first surface) of the wavelength converter 10 heats the phosphor 11 and the molten glass 12. The heat is conducted through the molten glass 12 as a heating medium to the substrate BS, which then dissipates the heat. The wavelength converter 10 with this structure has high heat resistance. The phosphor 11 may include the phosphor particles 11a coated with a coating layer. For the phosphor particles 11a being coated with the coating layer, the molten glass 12 being in direct contact with the phosphor particles 11a refers to the molten glass 12 being in direct contact with the coating layer on the phosphor particles 11a.

The molten glass 12 is transparent to allow laser light to enter the wavelength converter 10 to excite the phosphor 11, and to allow red, green, and blue fluorescence emitted from the excited phosphor 11 to be radiated outside.

The voids 13 are located at least between the phosphor particles 11a, in the molten glass 12, or between the phosphor particles 11a and the molten glass 12. As described above, the voids 13 are spaces in the wavelength converter 10 without any phosphor 11 or molten glass 12.

A higher volume ratio of the voids 13 to the phosphor 11 may cause lower light emission from the phosphor 11. A higher volume ratio of the voids 13 to the molten glass 12 may cause lower heat dissipation. However, multiple types of wavelength converters 10 formed under different conditions show that a certain volume of the voids 13 increases light emission from the phosphor 11.

FIG. 3 is a graph with the horizontal axis showing the porosity (%), the left vertical axis showing the resistance to laser radiation (W/mm²) of the wavelength converter 10, and the right vertical axis showing the total luminous flux (lm) emitted from the wavelength converter 10. In FIG. 3, the total luminous flux is indicated by outlined circles, and the resistance to laser radiation is indicated by solid circles.

The porosity is defined as, for example, a value obtained by dividing the total area of the voids 13 in a cross section S of the wavelength converter 10 by the total area of the cross section S of the wavelength converter 10. More specifically, the porosity may be defined as a value obtained by dividing the sum of the areas of multiple voids 13 in the cross section S of the wavelength converter 10 by the area of the cross section S of the wavelength converter 10. For example, the porosity may be determined from an SEM image illustrated in FIG. 2.

The SEM image may be obtained by, for example, cutting the wavelength converter 10, polishing the cross section, coating the cross section with an antistatic gold deposition film, and capturing an image of the coated cross section.

The wavelength converter 10 includes cavities in its cross section that are the voids 13. To cause the voids 13 to appear white and bright in an SEM image, the gold deposition film may be thicker than usual, and the voltage and the current for an electron gun for image capturing may be adjusted. This allows the voids 13 to be distinguishable from the phosphor 11 and the molten glass 12 and allows binarization.

The resistance to laser radiation is defined as the power of laser light at the time point at which the wavelength converter 10 is altered after continuous exposure to laser light while the power is gradually being increased. The resistance to laser radiation may be a parameter indicating the heat resistance of the wavelength converter 10.

The total luminous flux is defined as the light intensity of fluorescence emitted from the wavelength converter 10 in response to laser light with power that does not alter the wavelength converter 10.

The porosities, resistances to laser radiation, and total luminous fluxes are obtained from multiple types of wavelength converters 10 formed under different conditions. FIG. 3 shows the resulting characteristics.

As shown in FIG. 3, the resistance to laser radiation decreases as the porosity increases. However, the total luminous flux has a maximum value greater than or equal to 140 1m with the porosity being between 5 and 10%. To maximize the light emission from the phosphor 11, the wavelength converter 10 may be formed under conditions to have a porosity between 5 and 10%. To increase the resistance to laser radiation rather than the light emission, the wavelength converter 10 may be formed under conditions to have a porosity less than 5%. In this manner, the porosity of the wavelength converter 10 can be controlled to cause the wavelength conversion element 100 to have high light emission from the phosphor 11 and high resistance to laser radiation.

As illustrated in FIG. 2, the maximum area of the areas of the voids 13 is less than the maximum area of the areas of the particles of phosphor 11 in a cross-sectional view of the wavelength converter 10. This reduces the decrease in thermal conductivity caused by the voids 13, thus reducing the decrease in resistance to laser radiation. The area of each void 13 and the area of each phosphor particle 11a may be calculated using an SEM image as illustrated in FIG. 2. The area of each void herein refers to the area of each of the voids 13 in a cross-sectional view. The area of each phosphor particle refers to the area of each of the phosphor particles 11a in a cross-sectional view.

### Manufacturing Method

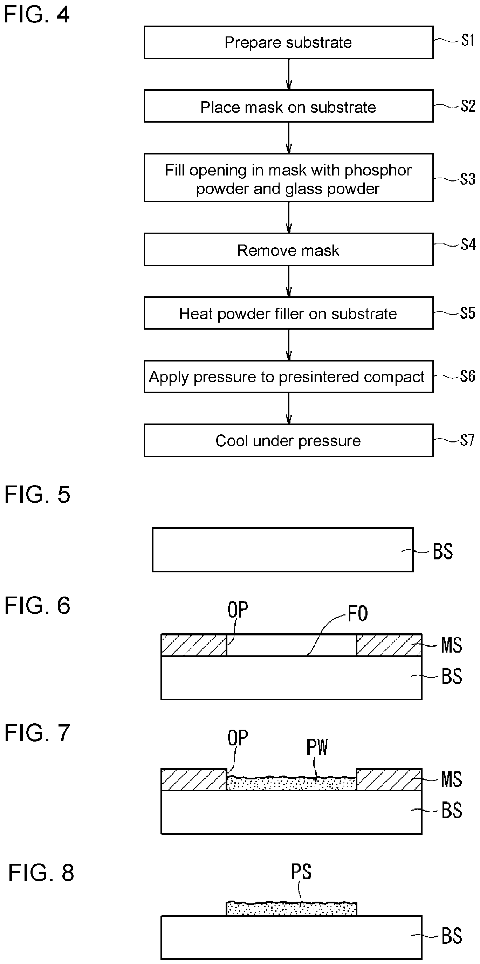

FIG. 4 is a flowchart showing processing for manufacturing the wavelength converter 10 with powder pressing. FIGs. 5 to 9 are cross-sectional views of the wavelength conversion element 100 illustrating the manufacturing processes. The method for manufacturing the wavelength conversion element 100 will now be described with reference to FIGs. 5 to 9 as well as FIG. 4.

As illustrated in FIG. 5, the substrate BS is prepared (step S1). The substrate BS may be made of a highly thermally conductive material that is transparent to visible light, such as sapphire or magnesia being a non-metallic material, or a highly thermally conductive material with high heat dissipation that is reflective to visible light, such as aluminum (Al) being a metallic material. The substrate BS may be made of a thermally conductive material transparent to visible light, or more specifically, a material transparent to visible light and having higher thermal conductivity than molten glass. The substrate BS may be made of, for example, a material with a thermal conductivity of greater than or equal to 30 W/(m·K).

The substrate BS made of, for example, aluminum as a reflective material may include an optically reflective film on its surface, or may have a mirror finish through physical or chemical polishing. This increases the reflectance of the substrate BS.

The non-metallic material may be, for example, aluminum nitride (AlN), gallium nitride (GaN), silicon carbide (SiC), silicon nitride (Si₃N₄), sapphire, or garnet. These non-metallic materials have low reflectance for visible light. The substrate BS made of, for example, AlN, may thus include an optically reflective film on its surface.

The substrate BS may be shaped and sized as appropriate for the size of the wavelength conversion element 100. For example, the substrate BS being rectangular in a plan view may have a thickness of 0.1 to 5 mm, a length of 0.5 to 30 mm, and a width of 0.5 to 30 mm. The substrate BS may be a heat sink.

As illustrated in FIG. 6, a metal mask MS is placed on a main surface F0 (upper surface) of the substrate BS on which the wavelength converter 10 is to be formed (step S2). The metal mask MS includes an opening OP corresponding to the shape of the wavelength converter 10 in a plan view.

For example, the metal mask MS may be made of aluminum and include the opening OP with any shape in a plan view formed by etching. The metal mask MS is thicker than the wavelength converter 10. For the wavelength converter 10 having a thickness of 0.1 mm, for example, the metal mask MS has a thickness of 0.15 to 0.2 mm. The metal mask MS may be replaced by a resin mask. The mask may be made of any material that allows the mask to include the opening with any shape and withstands subsequent filling with powder.

As illustrated in FIG. 7, a powder filler PW is formed by filling the opening OP in the metal mask MS with phosphor powder and glass powder (step S3). The phosphor powder includes one or more types of powdery phosphor. The one or more types of powdery phosphor correspond to the phosphor 11 described above and may include a red phosphor, a green phosphor, or a blue phosphor.

The red phosphor is, for example, a phosphor with a peak wavelength of fluorescence in a range of about 620 to 750 nm emitted in response to laser light. The red phosphor material is, for example, CaAlSiN₃:Eu, Y₃O₃S:Eu, Y₃O₃:Eu, SrCaClAlSiN₃:Eu²⁺, CaAlSiN₃:Eu, or CaAlSi(ON)₃:Eu.

The green phosphor is, for example, a phosphor with a peak wavelength of fluorescence in a range of about 495 to 570 nm emitted in response to laser light. The green phosphor material is, for example, β-SiAlON:Eu, SrSi3(O, Cl)₃N₃:Eu, (Sr, Ba, Mg)₂SiO₄:Eu²⁺, ZnS:Cu, Al, or Zn₃SiO₄:Mn.

The blue phosphor is, for example, a phosphor with a peak wavelength of fluorescence in a range of about 450 to 495 nm emitted in response to laser light. The blue phosphor material is, for example, (BaSr)MgAl₁₀O₁₇:Eu, BaMgAl₁₀O₁₇:Eu, (Sr, Ca, Ba)₁₀(PO₄)₆Cl₂:Eu, or (Sr, Ba)₁₀(PO₄)₆Cl₃:Eu.

The phosphor powder may have any of various particle size distributions. For example, the phosphor powder may include phosphor particles with a D50 particle size in a range of 0.1 to 100 µm, or specifically in a range of 10 to 20 µm.

In the powder filler PW, the content of glass powder may be about 10 to 70 wt% of the content of phosphor powder. Similarly to the phosphor powder, the glass powder may have any of various particle size distributions. For example, the glass powder may include glass particles with a D50 particle size in a range of 0.1 to 100 µm, or specifically in a range of 10 to 20 µm.

The glass powder may be low-melting glass, or specifically oxide glass having a melting point of 200 to 700 °C and being transparent after being sintered. The low-melting glass may mainly contain, for example, tin oxide, zinc oxide, boron oxide, bismuth oxide, boron oxide, vanadium oxide, tellurium oxide, or phosphoric acid. The low-melting glass may contain, for example, an oxide of alkali metal.

The phosphor powder and the glass powder may be mixed with vibration or rotation and rocking. The phosphor powder and the glass powder may be mixed using a medium. Various methods using the medium are available, such as dry mixing in which the powders are directly mixed or wet mixing in which the powders are mixed with, for example, a solvent or a binder.

As illustrated in FIG. 8, the metal mask MS is removed from the substrate BS after the powder filler PW is formed. The powder filler PW is then heated to form a presintered compact PS (step S5).

The heating temperature is higher than or equal to the melting point of the glass powder and lower than the temperature at which the phosphor loses fluorescence. The heating temperature may be, for example, 260 to 600 °C.

The powder filler PW is heated in a chamber that is also used for applying pressure to the powder filler PW (described later). The chamber can be evacuated to produce a vacuum during heating. Heated in a vacuum in the chamber, the glass powder melts with reduced bubbles.

The wavelength converter with a porosity of less than 5% described above with reference to FIG. 3 can be manufactured through heating in a vacuum in the chamber. The wavelength converter has a resistance to laser radiation of greater than or equal to 5 W/mm².

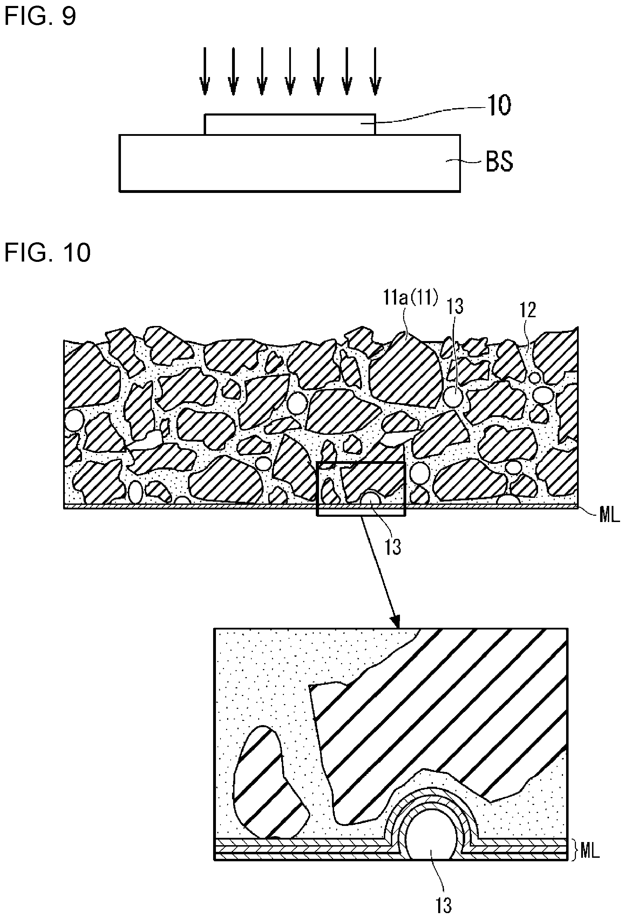

As illustrated in FIG. 9, after the heating temperature reaches a set temperature, pressure is applied to the presintered compact PS on the substrate BS maintained at the set temperature (step S6). The pressure applied in this process may be determined to prevent the phosphor from being physically crushed and failing to emit fluorescence. The pressure may be, for example, 300 to 1000 kgf/cm² (about 30 to 100 MPa).

The pressure satisfying the above condition may continue to be applied to the presintered compact PS for about one second to ten minutes. The presintered compact PS is then cooled under the pressure being maintained (step S7). The pressure is released in response to the temperature of the presintered compact PS dropping below the melting point of the glass powder.

The wavelength conversion element 100 formed through the above steps can include voids in the wavelength converter 10 as intended. The resulting wavelength conversion element 100 thus has high heat resistance.

The above manufacturing method may use the substrate BS made of a material that easily forms an oxide film, such as aluminum. In this case, the substrate BS and the wavelength converter 10 are bonded using oxidation. More specifically, oxygen in the oxide glass is bonded to oxygen in an oxide film formed on the surface of the substrate BS under heat to bond the substrate BS and the wavelength converter 10 using oxidation.

The above manufacturing method may use the substrate BS made of a material less likely to cause such oxidative bonding. In this case, the substrate BS may have microscopic surface roughness of, for example, several micrometers to increase contact with the molten glass and increase the bonding strength with an anchor effect. In other words, the substrate BS may have surface roughness (microscopic roughness). For example, the microscopic roughness herein may cause the low-melting glass liquefied under heat to flow and enter between irregular portions of the rough surface. The microscopic roughness may have a roughness value of, for example, 0.1 to 50 µm. The microscopic roughness may cause the phosphor particles to enter between irregular portions of the rough surface. In this case, the microscopic roughness may have a roughness value of, for example, 5 to 50 µm. In each case, the roughness value of the microscopic roughness may be smaller than the particle sizes of the phosphor powder and the particle sizes of the glass powder. The particle sizes of the phosphor powder and the particle sizes of the glass powder refer to the particle sizes of their raw powders before being mixed in manufacturing.

The substrate BS may have surface roughness having a roughness value less than the minimum size of the sizes of the phosphor particles. When the substrate BS has such a roughness value relative to the phosphor particle sizes, the substrate BS and the wavelength converter 10 can be bonded more strongly with an increased anchor effect.

The value of the microscopic roughness (the roughness value) of the substrate BS herein refers to, for example, the dimension between the valley (lowest point) and the peak (highest point) of the microscopic roughness in the thickness direction of the substrate BS. The sizes of the phosphor particles may be calculated using an SEM image illustrated in FIG. 2.

The substrate BS may be made of a material that cannot use the oxidative bonding or the anchoring effect. In this case, the wavelength converter 10 and the substrate BS may be prepared separately. More specifically, instead of being formed on the substrate BS, the wavelength converter 10 may be formed separately from the substrate BS by applying heat and pressure to the powder filler PW separately from the substrate BS. In this case, the wavelength converter 10 may include a metallic multilayer film on the surface to face the substrate BS and may be joined to the substrate BS by soldering.

The multilayer film may include, for example, thin films of titanium (Ti), platinum (Pt), and gold (Au) stacked in this order from the wavelength converter 10. The multilayer film may be formed by, for example, sputtering or vapor deposition to have a thickness of several to several hundred nanometers.

Ti can bond to oxide glass tightly. Au has high wettability with a solder material. The Pt film serves as a barrier that allows the Ti film to be less likely to peel off the wavelength converter 10 with the solder material being melted. Instead of the film of Ti/Pt/Au, the multilayer film may include a film of chromium (Cr)/Pt/Au or Cr/nickel (Ni)/Au. For example, the Ti film may have a thickness of about 0.1 µm, the Pt film may have a thickness of about 0.2 µm, and the Au film may have a thickness of about 0.2 µm.

The solder material may be tin (Sn)-phosphorus (P)-copper (Cu) solder or Au-Sn solder.

The multilayer film may further provide the advantages below. As described above, in the present embodiment, the wavelength converter 10 includes the voids 13 in a cross section as illustrated in FIG. 2. The wavelength converter 10 includes the voids 13 also in the surface facing the substrate BS. In other words, as illustrated in FIG. 2, the wavelength converter 10 has a surface F2 (second surface) facing the substrate BS and having roughness with recesses defined by the voids 13 as described above. For the wavelength converter 10 including the multilayer film with the above thickness, the multilayer film is located on the surface of the wavelength converter 10 facing the substrate BS and having the roughness defined by the voids 13. The multilayer film is located along the outer edges of the recesses. More specifically, as illustrated in FIG. 10, a multilayer film ML is located along the outer edges of the recesses defined by the voids 13 on the surface of the wavelength converter 10 facing the substrate BS (not illustrated). The roughness defined by the voids 13 has a roughness value smaller than the sizes of the phosphor particles.

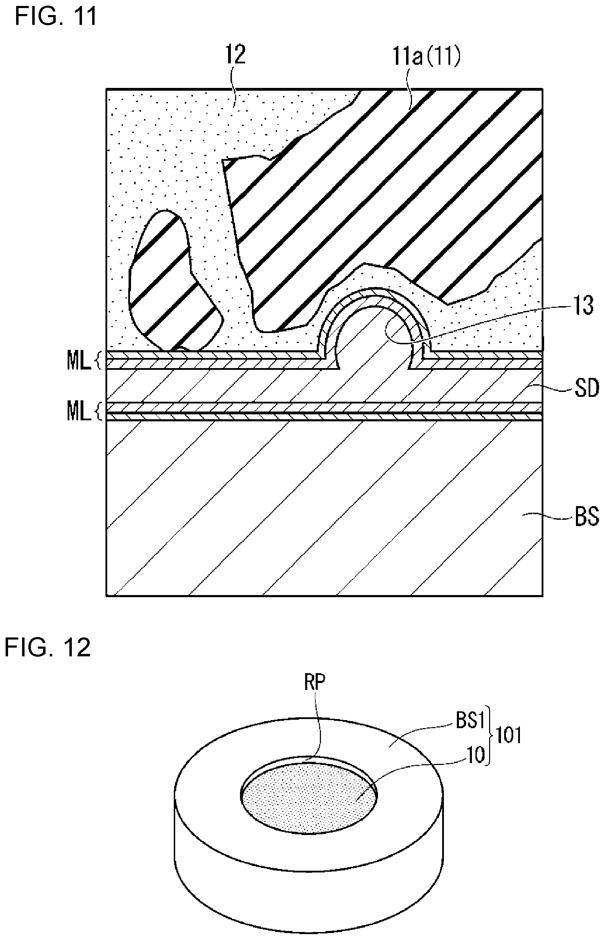

The wavelength converter 10 with this structure has higher wettability with the solder material and can be joined to the substrate BS with higher strength. FIG. 11 is a partial cross-sectional view of the wavelength converter 10 and the substrate BS, illustrating the boundary between them. The wavelength converter 10 and the substrate BS are separately prepared and joined together with solder. As illustrated in FIG. 11, the wavelength converter 10 includes the multilayer film ML on the surface facing the substrate BS, and the substrate BS also includes the multilayer film ML on its surface. A solder layer SD is between the wavelength converter 10 and the substrate BS. With this structure, the solder layer SD enters the voids 13, thus increasing the anchor effect and the thermal conductivity.

In the example of FIG. 2, the wavelength converter 10 may be divided into a first portion extending in the thickness direction from the first surface to receive excitation light and a second portion extending in the thickness direction from the second surface facing the substrate BS. The first portion has a first porosity being the ratio of the total area of the voids 13 in a cross section of the first portion to the total area of the cross section of the first portion. The second portion has a second porosity being the ratio of the total area of the voids 13 in a cross section of the second portion to the total area of the cross section of the second portion. The first porosity may be higher than the second porosity. This increases the light emission from the first portion and increases the thermal conductivity in the second portion. The difference between the first porosity and the second porosity may be, for example, 2 to 15%.

The wavelength converter 10 may include the first portion and the second portion in a manner different from those in the above example. The first portion may be any portion extending from the first surface in the thickness direction. The second portion may be any portion extending from the second surface in the thickness direction. In other words, a portion (first portion) adjacent to the first surface and a portion (second portion) adjacent to the second surface may simply have porosities satisfying the above condition. For example, the first portion may extend across a half or more of the entire thickness of the wavelength converter 10. More specifically, the first portion may extend from the first surface in the thickness direction across about 40% of the entire thickness of the wavelength converter 10, and the second portion may extend from the second surface in the thickness direction across about 60% of the entire thickness of the wavelength converter 10. The wavelength converter 10 with this structure has appropriate thermal conductivity and appropriate light emission.

The wavelength converter 10 including the first portion and the second portion as described above can be produced with various methods, such as bonding a first wavelength converter sheet and a second wavelength converter sheet with different porosities.

### Variations

In the embodiment illustrated in FIG. 1, the wavelength conversion element 100 includes the substrate BS being a plate and the wavelength converter 10 located on the upper surface F1 or a main surface of the substrate BS. However, the wavelength conversion element may have another structure as in, for example, a wavelength conversion element 101 illustrated in FIG. 12.

The wavelength conversion element 101 illustrated in FIG. 12 includes a substrate BS1 being a disk with a recess RP on its upper main surface at the center. The recess RP is circular in a plan view. The recess RP receives a wavelength converter 10.

With this structure, excitation light scattered or absorbed in the wavelength converter 10 without undergoing wavelength conversion can be reflected by the side surface of the recess RP on the substrate BS1 to return to the wavelength converter 10 for wavelength conversion. In other words, the wavelength converter 10 can perform wavelength conversion on the returning light.

The wavelength converter 10 has a side surface in contact with the side surface of the recess RP. This structure allows heat from the wavelength converter 10 to be dissipated outside through the side surface of the recess RP and the substrate BS1. This reduces the temperature rise of the wavelength converter 10.

### Manufacturing Method

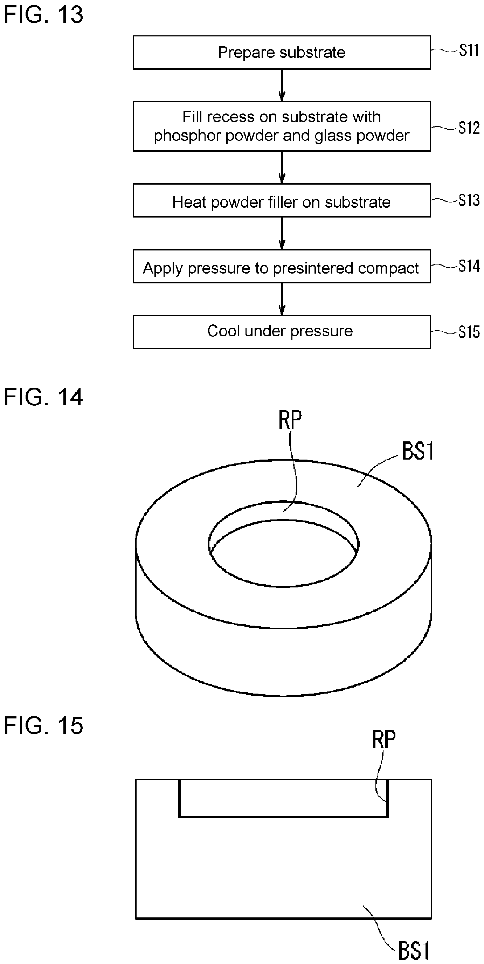

FIG. 13 is a flowchart showing a variation of the processing for manufacturing the wavelength converter 10 with powder pressing. The method for manufacturing the wavelength conversion element 101 will now be described with reference to FIG. 13.

First, the substrate BS1 as illustrated in FIGs. 14 and 15 is prepared (step S11). FIG. 14 is a general perspective view of the substrate BS1. FIG. 15 is a cross-sectional view of the substrate BS1. The substrate BS1 includes the recess RP with a depth of 0.01 to 1 mm. The substrate BS1 has a thickness of 0.05 to 10 mm below the bottom of the recess RP. The recess RP has a depth greater than the thickness of the wavelength converter 10. For the wavelength converter 10 having a thickness of 0.1 mm, for example, the recess RP has a depth of 0.15 to 0.2 mm. The substrate BS1 measures 0.5 to 30 mm across. The recess RP measures 0.1 to 10 mm across.

The substrate BS1 may be made of a material having a coefficient of thermal expansion close to that of the wavelength converter 10. More specifically, the substrate BS1 may be made of a metal material or an inorganic material having a coefficient of thermal expansion of ±50% of the coefficient of thermal expansion of the low-melting glass as the molten glass in the wavelength converter 10. For example, the substrate BS1 may be made of aluminum or an aluminum alloy as a metal material.

The substrate BS1 made of, for example, aluminum as a reflective material may include an optically reflective film on its surface, or may have a mirror finish through physical or chemical polishing. This increases the reflectance of the substrate BS1.

The substrate BS1 made of a metal material may be formed by machining including cutting or by molding including die casting.

The substrate BS1 may also be made of a ceramic material. In this case, the substrate BS1 may be formed by stacking ceramic layers or by powder pressing.

The method for forming the substrate BS1 by stacking ceramic layers may include stacking ring-shaped green sheets with a through-hole (corresponding to the recess RP) and disk-shaped green sheets without a through-hole on one another and sintering the stacked sheets.

The method for forming the substrate BS1 by powder pressing may include filling a die having a cylindrical hole with ceramic powder and pressing the ceramic powder with another die for forming a recess (corresponding to the recess RP). In this case, the ceramic powder is mixed with wax and a binder and pressed to form a compact including a recess (corresponding to the recess RP). The compact is then sintered to form the substrate BS1.

Examples of the ceramic for the substrate BS1 include alumina, aluminum nitride, silicon nitride, mullite, and zirconia.

The substrate BS1 may also be made of ceramic and metal. More specifically, a metallic ring (metallic member) made of, for example, aluminum or an aluminum alloy may be joined to a disk-shaped ceramic substrate with a bond to form the substrate BS1. The ring has a through-hole to be the recess RP. The bond may be a brazing material mainly containing silver (Ag) and copper (Cu). In some embodiments, the bond may be a brazing material mainly containing aluminum (Al), or may be solder mainly containing tin (Sn), silver (Ag), and copper (Cu), or may be a resin bond containing, for example, an epoxy resin, a silicone resin, or an acrylic resin. To have sufficient thermal conductivity, the resin bond may contain a highly thermally conductive filler, such as silver (Ag), aluminum nitride (AlN), or boron nitride (BN).

Further, the substrate BS1 may be formed by joining a ceramic ring to a ceramic substrate with a bond, instead of stacking ceramic layers and firing them together. This method may also use any of the above bonds.

Referring back to FIG. 13, a powder filler is formed by filling the recess RP on the substrate BS1 with phosphor powder and glass powder (step S12). The phosphor powder includes one or more types of powdery phosphor. The one or more types of powdery phosphor herein correspond to the phosphor 11 (FIG. 2) in the above embodiment and may include a red phosphor, a green phosphor, or a blue phosphor. The materials, the compositions, the mixing methods, and other features of the phosphor and the powder filler have been described in the above embodiment, and will not be described repeatedly.

The powder filler in the recess RP on the substrate BS1 is heated together with the substrate BS1 to form a presintered compact (step S13).

After the heating temperature reaches a set temperature, pressure is applied to the presintered compact on the substrate BS1 maintained at the set temperature (step S14).

The heating of the powder filler and the application of pressure to the powder filler have been described in the above embodiment, and will not be described repeatedly.

The presintered compact is then cooled under the pressure applied being maintained (step S15). The pressure is released in response to the temperature of the presintered compact dropping below the melting point of the glass powder.

The wavelength conversion element 101 formed through the above steps can include voids in the wavelength converter 10 as intended. The resulting wavelength conversion element 101 thus has high heat resistance.

The substrate BS1 includes the recess RP in which the powder filler is formed. This eliminates step S2 for placing a mask on the substrate and removing the mask, unlike the manufacturing method in the embodiment described with reference to FIG. 4, thus simplifying the manufacturing processes.

In the wavelength conversion element 101 illustrated in FIG. 12, the substrate BS1 is a disk with the recess RP in its upper surface, and the recess RP is circular in a plan view. However, the substrate BS1 is not limited to a disk, and the recess RP is not limited to being circular in a plan view.

The above embodiments may be changed or omitted as appropriate within the scope of the present disclosure.

## Claims

1. A wavelength conversion element for converting excitation light to light with a different wavelength, the wavelength conversion element comprising:
a substrate including an upper surface; and
a wavelength converter on the upper surface of the substrate, the wavelength converter including
a phosphor including a plurality of phosphor particles,
molten glass in contact with the plurality of phosphor particles and binding the plurality of phosphor particles to one another, and
voids at least between the plurality of phosphor particles, in the molten glass, or between the plurality of phosphor particles and the molten glass,
wherein a maximum area of areas of the voids is less than a maximum area of areas of the plurality of phosphor particles in a cross-sectional view of the wavelength converter.

2. The wavelength conversion element according to claim 1, wherein
the wavelength converter has a porosity of 5 to 10%, where the porosity is a ratio of a total area of the voids in a cross section of the wavelength converter to a total area of the cross section.

3. The wavelength conversion element according to claim 1 or claim 2, wherein
the molten glass includes low-melting glass having a melting point of 200 to 700 °C and being transparent to visible light.

4. The wavelength conversion element according to any one of claims 1 to 3, wherein
the substrate comprises a thermally conductive material transparent to visible light.

5. The wavelength conversion element according to claim 4, wherein
the substrate comprises sapphire or magnesia.

6. The wavelength conversion element according to any one of claims 1 to 3, wherein
the substrate comprises a thermally conductive material reflective to visible light.

7. The wavelength conversion element according to claim 6, wherein
the substrate includes an optically reflective film on the upper surface.

8. The wavelength conversion element according to any one of claims 1 to 7, wherein
the wavelength converter includes a first surface to receive the excitation light and a second surface on the upper surface of the substrate, and
the second surface has roughness.

9. The wavelength conversion element according to claim 8, wherein
the roughness has a roughness value less than a minimum size of sizes of the plurality of phosphor particles.

10. The wavelength conversion element according to claim 8 or claim 9, wherein
the first surface and the second surface are opposite to each other in a thickness direction of the wavelength converter,
the wavelength converter includes a first portion extending from the first surface in the thickness direction and a second portion extending from the second surface in the thickness direction, and
the first portion has a first porosity being a ratio of a total area of the voids in a cross section of the first portion to a total area of the cross section of the first portion, the second portion has a second porosity being a ratio of a total area of the voids in a cross section of the second portion to a total area of the cross section of the second portion, and the first porosity is higher than the second porosity.

11. A method for manufacturing a wavelength conversion element, the wavelength conversion element including a wavelength converter for converting excitation light to light with a different wavelength, the method comprising:
forming a powder filler comprising phosphor powder and glass powder;
heating the powder filler to form a presintered compact;
applying pressure to the presintered compact maintained at a temperature higher than or equal to a melting point of the glass powder and lower than a temperature at which a phosphor loses fluorescence; and
cooling the presintered compact under the pressure to form the wavelength conversion element.

12. The method according to claim 11, further comprising:
preparing a substrate,
wherein forming the powder filler comprising the phosphor powder and the glass powder includes
placing a mask including an opening on the substrate,
filling the opening in the mask with the phosphor powder and the glass powder, and
removing the mask from the substrate.

13. The method according to claim 11, further comprising:
preparing a substrate including a recess,
wherein forming the powder filler comprising the phosphor powder and the glass powder includes filling the recess on the substrate with the phosphor powder and the glass powder.

14. The method according to any one of claims 11 to 13, wherein
heating the powder filler to form the presintered compact includes heating the powder filler in a vacuum.

15. The method according to any one of claims 11 to 14, wherein
the glass powder includes low-melting glass having a melting point of 200 to 700 °C and being transparent to visible light.

16. A wavelength conversion element, comprising:
a substrate; and
a wavelength converter on the substrate, the wavelength converter including
a phosphor including a plurality of phosphor particles,
molten glass in contact with the plurality of phosphor particles and binding the plurality of phosphor particles to one another, and
voids at least between the plurality of phosphor particles, in the molten glass, or between the plurality of phosphor particles and the molten glass,
wherein the wavelength converter has a heat resistance for the excitation light and a total luminous flux of fluorescence generated from the phosphor in response to the excitation light, and the heat resistance and the total luminous flux are determined based on a porosity being a ratio of a total area of the voids in a cross section of the wavelength converter to a total area of the cross section.
